(19) Europäisches Patentamt
European Patent Office
Office européen des brevets

(11) **EP 3 617 718 B1**

(12) **EUROPÄISCHE PATENTSCHRIFT**

(45) Veröffentlichungstag und Bekanntmachung des Hinweises auf die Patenterteilung:
**10.05.2023 Patentblatt 2023/19**

(21) Anmeldenummer: **19192873.8**

(22) Anmeldetag: **21.08.2019**

(51) Internationale Patentklassifikation (IPC):
*G01R 19/25* (2006.01)    *H03M 1/12* (2006.01)

(52) Gemeinsame Patentklassifikation (CPC):
*G01R 19/2509; H03M 1/1265;* G01R 31/3835

(54) **VERFAHREN UND VORRICHTUNG ZUR ANALOG-DIGITAL-WANDLUNG, ELEKTRISCHES NETZ**

METHOD AND DEVICE FOR ANALOG TO DIGITAL CONVERSION, ELECTRICAL NETWORK

PROCÉDÉ ET DISPOSITIF DE CONVERSION ANALOGIQUE-NUMÉRIQUE, RÉSEAU ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.08.2018 DE 102018214402**

(43) Veröffentlichungstag der Anmeldung:
**04.03.2020 Patentblatt 2020/10**

(73) Patentinhaber: **Volkswagen AG**
**38440 Wolfsburg (DE)**

(72) Erfinder: **Juhl, Jochen**
**31702 Lüdersfeld (DE)**

(74) Vertreter: **Clarenbach, Carl-Philipp et al**
**Gleiss Große Schrell und Partner mbB**
**Patentanwälte Rechtsanwälte**
**Leitzstraße 45**
**70469 Stuttgart (DE)**

(56) Entgegenhaltungen:
DE-A1- 4 019 001    DE-A1-102014 107 540
DE-A1-102015 212 242    DE-U1-202014 004 689

**Beschreibung**

Die Erfindung betrifft ein Verfahren zur Analog-Digital-Wandlung von einem analogen, zumindest im Wesentlichen kontinuierlichen Eingangssignal, das ein durch zumindest zwei Störsignale mit unterschiedlichen Frequenzen überlagertes Nutzsignal aufweist, in ein digitales Ausgangssignal, wobei das Eingangssignal in einem beschränkten Messzyklus abgetastet wird, und wobei Anzahl und Zeitpunkte der mehreren Abtaststellen innerhalb des Messzyklus in Abhängigkeit von einer Frequenz des Eingangssignals bestimmt werden.

Weiterhin betrifft die Erfindung eine Vorrichtung zur Durchführung des vorstehend genannten Verfahrens, sowie ein elektrisches Netz, insbesondere Bordnetz oder Traktionsnetz eines Kraftfahrzeugs, mit einer solchen Vorrichtung.

Verfahren der eingangs genannten Art sind aus dem Stand der Technik bekannt. So offenbart beispielsweise die Offenlegungsschrift DE 24 55 302 A1 ein Verfahren zur Analog-Digital-Wandlung, bei welchem ein analoges Eingangssignal bei begrenzter Abtastrate überlagerten äquidistanten und zumindest pseudo-stochastischen variierten Abtastintervallen unterzogen wird. Dadurch soll ohne spürbare Steigerung der Anlagekosten eine gesteigerte Auflösung des analogen Eingangssignals erzielt werden. Als bekannt wird vorausgesetzt, dass ein analoges Eingangssignal unter Berücksichtigung des Shannon- oder Nyquist-Theorem abgetastet wird. Dieses besagt, dass die Anzahl der Abtastung pro Messzyklus größer als 2 sein muss, und dass die Anzahl der Abtastungen pro Messzyklus eine ganze Zahl ist, wie beispielsweise in der Offenlegungsschrift DE 10 2007 043 927 A1 zusammengefasst. Dort wird außerdem vorgeschlagen, eine Schätzfrequenz für die Signalfrequenz zu ermitteln und die Abtastfrequenz in Abhängigkeit von der Schätzfrequenz und damit letztendlich von der abgenommenen Signalfrequenz zu bestimmen. Auch aus der Offenlegungsschrift US 5,815,101 A ist ein Verfahren zur Druckdigitalwandlung bekannt, bei welchem das Eingangssignal mit einer ersten Sampling-Rate und mit einer zweiten Sampling-Rate gesampelt wird.

Aus den Offenlegungsschriften DE 40 19 001 A1, DE 10 2015 212 242 A1 und DE 10 2014 107 540 A1 sind weitere Verfahren zur Analog-Digital-Wandlung bekannt.

In der Praxis zeigt sind, dass beispielsweise im Traktionsnetz eines Kraftfahrzeugs das elektrische Netz insbesondere im Bereich einer Traktionsbatterie durch Störsignale überlagert ist. Bei der Überwachung der Batteriezellen wird als Eingangssignal die Batteriespannung oder die Zellspannung erfasst. Das Spannungssignal ist dabei häufig von zwei Störsignalen überlagert, welche unterschiedliche Frequenzen aufweisen, sodass von einem hochfrequenten und einem niederfrequenten Störsignal gesprochen wird.

Wird das Signal nun mit äquidistanten Abtaststellen im Messzyklus abgetastet, ergibt sich ein verhältnismäßig hoher Messfehler. Die im oben genannten Stand der Technik vorgeschlagenen Verfahren können den Messfehler nicht zufriedenstellend weit reduzieren.

Der Erfindung liegt daher die Aufgabe zugrunde, ein verbessertes Verfahren zur Analog-Digital-Wandlung zu schaffen, bei welchem der Messfehler auf ein Minimum reduziert ist.

Die der Erfindung zugrundeliegende Aufgabe wird durch das Verfahren mit den Merkmalen des Anspruchs 1 gelöst. Dieses führt dazu, dass der Messfehler bei der Analog-Digital-Wandlung auf einfache Art und Weise auf ein Minimum reduziert wird, wobei die Anzahl der insgesamt vorgesehenen Abtastungen über ein bisher mögliches Maß nicht hinausgesteigert werden muss. Erfindungsgemäß wird dies dadurch erreicht, dass die Abtaststellen in Abhängigkeit von den Frequenzen der Störsignale bestimmt werden. Dadurch werden die Abtaststellen auf die Störsignale abgestimmt und angepasst, sodass insbesondere Minima und Maxima der Störsignale besser erfasst werden können, wodurch der Messfehler reduzierbar ist.

Erfindungsgemäß werden zumindest zwei Abtaststellen in Abhängigkeit von der Frequenz des niederfrequenten Störsignals und zumindest zwei Abtaststellen in Abhängigkeit von der Frequenz des hochfrequenten Störsignals bestimmt. Damit werden gemäß dieser Ausführungsform bevorzugt zumindest vier Abtaststellen insgesamt vorgegeben, wobei zwei von dem niederfrequenten Signal und zwei von dem hochfrequenten Steuersignal abhängen. Insbesondere werden die Abtaststellen dabei in Abhängigkeit von der Periodendauer des jeweiligen Störsignals bestimmt. Durch das Verwenden von mindestens vier Abtaststellen, zwei für jedes der Störsignale, wird eine erfolgreiche Reduzierung des Messfehlers erreicht. Dadurch, dass die Abtaststellen in Abhängigkeit von den Frequenzen der Störsignale bestimmt werden, wird eine weitere Reduzierung des Messfehlers erreicht.

Erfindungsgemäß sind für einen Messzyklus vier Abtaststellen gewählt, eine Messperiode also auf vier Abtaststellen beschränkt, wobei eine erste Abtaststelle und eine zweite Abtaststelle in einem Abstand von einer halben und mindestens einer ganzen Periodendauer des niederfrequenten Störsignals gewählt werden. Die erste und die zweite Abtaststelle werden somit in Abhängigkeit von dem niederfrequenten Störsignal vorgegeben und weisen einen Abstand zueinander auf, der zumindest einer anderthalbfachen Periodendauer, einer zweieinhalbfachen, einer dreieinhalbfachen, einer viereinhalbfachen Periodendauer usw. des niederfrequenten Störsignals entspricht. Dies wird mit dem Ziel verfolgt, ein Maximum und ein Minimum des Störsignals erfassen zu können, wodurch eine vorteilhafte Berücksichtigung des niederfrequenten Störsignals zur Messfehlerreduzierung erreicht wird.

Weiterhin ist erfindungsgemäß vorgesehen, dass die zumindest zwei in Abhängigkeit von dem hochfrequenten Störsignal gewählten Abtaststellen in Abhängigkeit von der ersten und der zweiten Abtaststelle bestimmt werden. Insbesondere werden die zwei weiteren Abtaststellen um die erste und die zweite Abtaststelle herum positioniert, um in der Nähe von Maxima und Minima des niederfrequenten Störsignals das hochfrequente Störsignal zu erfassen. Hierdurch wird der Messfehler weiter reduziert.

Erfindungsgemäß wird eine dritte Abtaststelle eine halbe Periodendauer des hochfrequenten Störsignals vor oder nach der ersten Abtaststelle gesetzt, und eine vierte Abtaststelle eine halbe Periodendauer des hochfrequenten Störsignals vor oder nach der zweiten Abtaststelle. Durch die gewählten Abstände der Abtaststellen voneinander wird gewährleistet, dass theoretisch die Maxima und Minima des hochfrequenten Störsignals erfasst werden und dadurch der Messfehler weiter reduziert wird.

Gemäß einer bevorzugten Weiterbildung der Erfindung wird eine fünfte Abtaststelle eine ganze Periodendauer vom hoch hochfrequenten Störsignal vor oder nach der dritten oder vierten Abtaststelle gesetzt. Dadurch wird die Abtastfrequenz in dem Messzyklus erhöht und durch eine vorteilhafte Platzierung der fünften Abtaststelle der Messfehler weiter reduziert.

Besonders bevorzugt werden die Frequenzen der Störsignale vorab ermittelt, sodass sie für die Durchführung des Verfahren bekannt und nutzbar sind.

Die erfindungsgemäße Vorrichtung mit den Merkmalen des Anspruchs 4 zeichnet sich durch ein Steuergerät aus, das speziell dazu hergerichtet ist, bei bestimmungsgemäßem Gebrauch das erfindungsgemäße Verfahren durchzuführen. Es ergeben sich hierdurch die bereits genannten Vorteile.

Das erfindungsgemäße elektrische Netz mit den Merkmalen des Anspruchs 5, insbesondere Bordnetz oder Traktionsnetz eines Kraftfahrzeugs, zeichnet sich durch die erfindungsgemäße Vorrichtung aus. Es ergeben sich die genannten Vorteile.

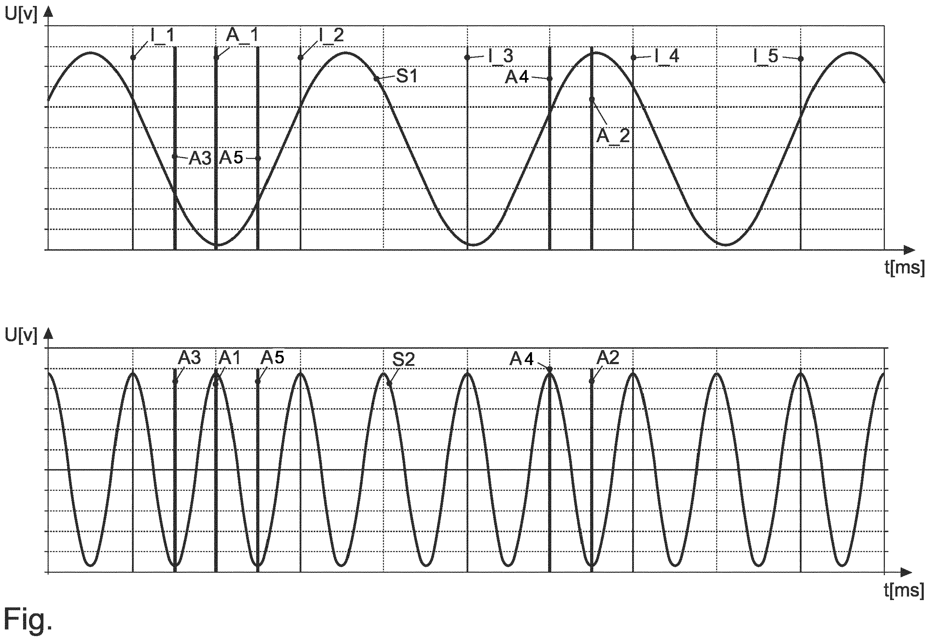

Weitere Vorteile und bevorzugte Merkmale und Merkmalskombinationen ergeben sich aus dem zuvor Beschriebenen sowie aus den Ansprüchen. Im Folgenden soll die Erfindung anhand der Zeichnung näher erläutert werden. Dazu zeigt die einzige

Figur ein Diagramm zur Erläuterung eines vorteilhaften Verfahrens zum Betreiben einer Analog-Digital-Wandlung.

Die einzige Figur zeigt in einem vereinfachten Diagramm beispielhaft den Verlauf von zwei Störsignalen S1, S2, die eine unterschiedliche Frequenz aufweisen und ein Nutzsignal überlagern.

Es wird davon ausgegangen, dass die Störsignale S1 und S2 ein Nutzsignal, beispielsweise das Spannungssignal eines Energiespeichers eines Kraftfahrzeugs, überlagern und zusammen mit dem Nutzsignal das abzutastende Eingangssignal bilden. Der Einfachheit halber sind in der Figur die Störsignale S1 und S2 übereinander gezeichnet. Die Störsignale S1 und S2 sind als periodische, vorliegend sinusförmige Signale, insbesondere zeitkontinuierlich und mit bekannter Frequenz vorausgesetzt. Dazu werden die Störsignale S1 und S2 beispielsweise vorab in dem System erfasst oder berechnet. Vorliegend weist das Störsignal S1 eine Frequenz von 33 Hertz und das Störsignal S2 eine Frequenz von 100 Hertz auf. Die Störamplitude liegt dabei jeweils bei 240 mV, das Nutzsignal bei 3,7 V.

Das Eingangssignal wird zur Analog-Digital-Wandlung abgetastet, wobei innerhalb eines Messfensters oder Messzyklus maximal vier Abtaststellen zur Verfügung stehen. Dabei spannt sich ein Messzyklus vorliegend über 100 ms, alternativ über 80 ms. Während bisher äquidistante Abtaststellen genutzt werden, wie durch fünf horizontale erste Linien I_1 bis I_5 bei dem Messzyklus von 100 ms gekennzeichnet, bei dem Messzyklus von 80 ms werden nur vier äquidistante Abtaststellen verwendet, hat sich jedoch gezeigt, dass sich hierdurch ein verhältnismäßig großer Messfehler bei der Auswertung beziehungsweise bei der Analog-Digital-Wandlung ergibt. Durch eine einfache Erhöhung der Anzahl der Abtaststellen könnte jeweils der Messfehler einfach reduziert werden, jedoch ist dies nur unter bestimmten Voraussetzungen möglich, die durch das Verarbeitungssystem vorgegeben werden. So ist beispielsweise im Traktionsnetz eines Kraftfahrzeugs eine Erfassung von mehr als fünf Abtaststellen in dem genannten Zeitintervall von 100 ms oder von mehr als vier Abtaststellen in dem kürzeren Zeitintervall von 80 ms des Messzyklus nicht möglich.

Um dennoch den Messfehler zu reduzieren, sieht das vorteilhafte Verfahren vor, dass die Abtaststellen in Abhängigkeit von den Frequenzen des Störsignals S1 uns S2 bestimmt werden. Dabei werden eine erste Abtaststelle A1 und eine zweite Abtaststelle A2 in Abhängigkeit von dem niederfrequenten Störsignal S1 vorgegeben. Der Abstand zwischen den Abtaststellen A1 und A2 zueinander wird in Abhängigkeit von der Periodendauer beziehungsweise der Frequenz des Störsignals S1 derart gewählt, dass er eine halbe und zumindest eine ganze Periode beträgt. Dies kann wie folgt beschrieben werden:

$$x_1 = 1/2 i T_1 + n i T_1,$$

wobei $x_1$ der Abstand zwischen den Abtaststellen A1 und A2 ist, $T_1$ die Periodendauer des niederfrequenten Störsignals S1 und n eine ganze Zahl (0,1,2,3,4, ...). Dies hat zur Folge, dass beispielsweise dann, wenn die Abtaststelle A1, wie in der Figur gezeigt, im Minimum des Störsignals S1 liegt, die zweite Abtaststelle A2 in einem Maximum liegt.

Die zwei verbleibenden Abtaststellen A3 und A4 der insgesamt bevorzugt vier Abtaststellen werden in Abhängigkeit des hochfrequenten Störsignals S2, so wie in Abhängigkeit von der Position der Abtaststellen A1 und A2 vorgegeben:

Die dritte Abtaststelle A3 wird zeitlich vor oder nach (in der Figur davor) der ersten Abtaststelle A1 platziert, und zwar in einem Abstand von einer halben Periodendauer $T_2$ des hochfrequenten Störsignals S2. Dadurch liegen die Abtaststellen A3 und A4 eine ganze Periodendauer des Störsignals S2 voneinander entfernt, sodass sie beispielsweise, wie in der Figur gezeigt, jeweils im Minimum des Störsignals S2 liegen.

Die vierte Abtaststelle A4 wird eine halben Periodendauer $T_2$ des Störsignals S2 vor der zweiten Abtaststelle A2 platziert. Dadurch ist die vierte Abtaststelle A4 eine halbe und mehrere ganze Periodendauern $T_2$ von der Abtaststelle A3 entfernt, sodass sie in einem Maximum liegt, wenn die Abtaststelle A3 in einem Minimum des Störsignals 2 liegt. Dieser Abstand $x_2$ kann wie folgt beschrieben werden:

$$x_2 = 1/2T_2 + nT_2,$$

wobei $x_2$ der Abstand zwischen den Abtaststellen A3 und A4 des zweiten Störsignals S2 ist, $T_2$ die Periodendauer des zweiten Störsignals S2 und n eine ganze Zahl (0,1,2,3,4,5, ...).

Optional wird eine fünfte Abtaststelle A5 gesetzt, die eine Periodendauer $T_2$ von dem zweiten Störsignal S2 vor oder nach der dritten oder vierten Abtaststelle gesetzt wird, im vorliegenden Ausführungsbeispiel davor. Vorzugsweise werden bei einem Messzyklus von 100 ms fünf Abtaststellen und bei einem Messzyklus von 80 ms nur vier Abtaststellen gesetzt.

Es hat sich gezeigt, dass sich dadurch ein Messfehler bei der Abtastung der Störsignale S1, S2 deutlich reduzieren lässt. So ist beispielsweise der Messfehler des niederfrequenten Signals S1 um 13 mV reduzierbar und der Messfehler des hochfrequenten Störsignals S2 um 192 mV. Dadurch ergibt sich eine genauere und verlässlichere Analog-Digital-Wandlung des Eingangssignals.

Insbesondere wird dieses Verfahren bei oder von einem Batteriezellenkontroller durchgeführt, der die Ladespannung der Batteriezelle überwacht. Dadurch ist eine besonders genaue Erfassung der Ladespannung der Batteriezelle möglich. Jedoch kann das Verfahren auch bei jeder anderen Anwendung einer Analog-Digital-Wandlung eingesetzt werden.

**Bezugszeichenliste**

S1    Störsignal
S2    Störsignal
I_1    Linie
I_2    Line
I_3    Linie
I_4    Linie
I_5    Linie
A1    Abtaststelle
A2    Abtaststelle
A3    Abtaststellen
A4    Abtaststellen
A5    Abtaststellen

**Patentansprüche**

1. Verfahren zur Analog-Digital-Wandlung von einem analogen, zumindest im Wesentlichen kontinuierlichen Eingangssignal, das ein durch zumindest zwei Störsignale (S1,S2) mit unterschiedlichen Frequenzen überlagertes Nutzersignal aufweist, in ein digitales Ausgangssignal, wobei das Eingangssignal in einem beschränkten Messzyklus abgetastet wird, und wobei Anzahl und Zeitpunkte von mehreren Abtaststellen (A1-A5) innerhalb des Messzyklus in Abhängigkeit von einer Frequenz des Eingangssignals bestimmt werden, wobei zumindest zwei Abtaststellen (A1 ,A2) in Abhängigkeit von der Frequenz des niederfrequenten Störsignals (S1) und zumindest zwei Abtaststellen (A3-A4) in Abhängigkeit von der Frequenz des hochfrequenten Störsignales (S2) bestimmt werden, wobei in einem Messzyklus zumindest vier Abtaststellen (A1-A4) gewählt werden, von denen eine erste Abtaststelle (A1) und eine zweite Abtaststelle (A2) in einem Abstand ($x_1$) von einer halben und einer oder mehreren ganzen Periodendauern ($T_1$) des niederfrequenten Störsignals (S1) gewählt werden, wobei die zwei in Abhängigkeit von dem hochfrequenten Störsignal (S2) gewählten Abtaststellen (A3-A4) in Abhängigkeit von der ersten und der zweiten Abtaststelle (A1,A2) bestimmt werden, und wobei eine dritte Abtaststelle (A3) in einem Abstand ($x_2$) von einer halben Periodendauer (1/2 $T_2$) vom hochfrequenten Störsignal (S2) vor oder nach der ersten Abtaststelle (A1) gesetzt wird, und eine vierte Abtaststelle (A4) eine halbe Periodendauer (1/2 $T_2$) des hochfrequenten Störsignals (S2) vor oder nach der zweiten Abtaststelle (A2).

2. Verfahren nach Anspruch 1, **dadurch gekennzeichnet, dass** eine fünfte Abtaststelle (A5) eine Periodendauer vom hochfrequenten Störsignal (S2) vor oder nach der dritten oder vierten Abtaststelle (A3,A4) gesetzt wird.

3. Verfahren nach einem der vorhergehenden Ansprüche, **dadurch gekennzeichnet, dass** die Frequenzen der Störsignale (S1,S2) vorab ermittelt werden.

4. Vorrichtung zur Durchführung des Verfahrens nach einem der Ansprüche 1 bis 3, **gekennzeichnet durch** ein Steuergerät, das speziell dazu hergerichtet ist, bei bestimmungsgemäßem Gebrauch das Verfahren nach einem der Ansprüche 1 bis 3 auszuführen.

5. Elektrisches Netz, insbesondere Bordnetz oder Traktionsnetz eines Kraftfahrzeugs, **gekennzeichnet durch** eine Vorrichtung nach Anspruch 4.

## Claims

1. A method for analog-to-digital conversion from an analog, at least substantially continuous input signal, which has a user signal superimposed by at least two interference signals (S1, S2) having different frequencies, into a digital output signal, wherein the input signal is sampled in a limited measurement cycle, and wherein the number and points in time of a plurality of sampling points (A1-A5) within the measurement cycle are determined as a function of a frequency of the input signal, wherein at least two sampling points (A1, A2) are determined as a function of the frequency of the low-frequency interference signal (S1) and at least two sampling points (A3-A4) are determined as a function of the frequency of the high-frequency interference signal (S2), wherein at least four sampling points (A1-A4) are selected in a measurement cycle, of which a first sampling point (A1) and a second sampling point (A2) are selected at a distance ($x_1$) of a half period duration and one or more whole period durations ($T_1$) of the low-frequency interference signal (S1), wherein the two sampling points (A3-A4) selected as a function of the high-frequency interference signal (S2) are determined as a function of the first and second sampling points (A1, A2), and wherein a third sampling point (A3) is placed at a distance ($x_2$) of a half period duration ($1/2\ T_2$) of the high-frequency interference signal (S2) before or after the first sampling point (A1), and a fourth sampling point (A4) is placed at a distance of a half period duration ($1/2\ T_2$) of the high-frequency interference signal (S2) before or after the second sampling point (A2).

2. Method according to claim 1, **characterized in that** a fifth sampling point (A5) is placed one period duration of the high-frequency interference signal (S2) before or after the third or fourth sampling point (A3, A4).

3. Method according to any of the preceding claims, **characterized in that** the frequencies of the interference signals (S1, S2) are determined in advance.

4. Device for carrying out the method according to any of claims 1 to 3, **characterized by** a controller, which is specifically designed to carry out the method according to any of claims 1 to 3 when used as intended.

5. Electrical network, in particular an onboard network or traction network of a motor vehicle, **characterized by** a device according to claim 4.

## Revendications

1. Procédé de conversion analogique-numérique d'un signal d'entrée analogique, au moins essentiellement continu, qui présente un signal d'utilisateur superposé par au moins deux signaux parasites (S1, S2) de fréquences différentes, en un signal de sortie numérique, dans lequel le signal d'entrée est échantillonné dans un cycle de mesure limité et dans lequel le nombre et les instants de plusieurs points d'échantillonnage (A1-A5) sont déterminés au sein du cycle de mesure en fonction d'une fréquence du signal d'entrée, dans lequel au moins deux points d'échantillonnage (A1, A2) sont déterminés en fonction de la fréquence du signal parasite basse fréquence (S1) et au moins deux points d'échantillonnage (A3-A4) sont déterminés en fonction de la fréquence du signal parasite haute fréquence (S2), dans lequel dans un cycle de mesure, au moins quatre points d'échantillonnage (A1-A4) sont sélectionnés, dont un premier point d'échantillonnage (A1) et un deuxième point d'échantillonnage (A2) sont sélectionnés à une distance ($x_1$) d'une ou plusieurs durées de période ($T_1$) entières et une moitié du signal parasite basse fréquence (S1), dans lequel les deux points d'échantillonnage (A3-A4) sélectionnés en fonction du signal parasite haute fréquence (S2) sont déterminés en fonction du premier et du deuxième point d'échantillonnage (A1, A2) et dans lequel un troisième point d'échantillonnage (A3) est défini à une distance ($x_2$) d'une demi-durée de période ($1/2\ T_2$) du signal parasite haute fréquence (S2) avant ou après le premier point d'échantillonnage (A1) et un quatrième point d'échantillonnage (A4) est défini à une demi-durée de période ($1/2\ T_2$) du signal parasite haute fréquence (S2) avant ou après le deuxième point d'échantillonnage (A2).

2. Procédé selon la revendication 1, **caractérisé en ce qu'**un cinquième point d'échantillonnage (A5) est défini à une durée de période du signal parasite haute fréquence (S2) avant ou après le troisième ou quatrième point d'échantillonnage (A3, A4).

3. Procédé selon l'une quelconque des revendications précédentes, **caractérisé en ce que** les fréquences des signaux parasites (S1, S2) ont été déterminées à l'avance.

4. Dispositif pour la réalisation du procédé selon l'une des revendications 1 à 3, **caractérisé par** un appareil de commande, qui est spécialement conçu, lors d'un usage adéquat, pour réaliser le procédé selon l'une des revendications 1 à 3.

5. Réseau électrique, en particulier réseau de bord ou réseau de traction d'un véhicule automobile, **caractérisé par** un dispositif selon la revendication 4.

Fig.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 2455302 A1
- DE 102007043927 A1
- US 5815101 A
- DE 4019001 A1
- DE 102015212242 A1
- DE 102014107540 A1